# EUROPEAN PATENT SPECIFICATION

(11) **EP 3 951 417 B1**
(45) Date of publication and mention of the grant of the patent: **01.05.2024**
(21) Application number: 20190120.4
(22) Date of filing: 07.08.2020
(51) Int. Cl.: G01R 33/38, G01R 33/383, G01R 33/3873, G01R 33/50, G01R 33/563, G01N 24/08, G01R 33/34, G01R 33/341

(54) **NMR-SENSOR WITH A V-SHAPED SAMPLE SPACE FOR ANALYSIS OF LIQUIDS**
NMR-SENSOR MIT EINEM V-FÖRMIGEN PROBENRAUM ZUR ANALYSE VON FLÜSSIGKEITEN
CAPTEUR RMN AVEC UN ESPACE POUR ÉCHANTILLON EN V POUR L'ANALYSE DE LIQUIDES

(43) Date of publication of application: 09.02.2022
(73) Proprietor: Bruker Biospin GmbH & Co. KG, 76275 Ettlingen (DE)
(72) Inventor: NIRSCHL, Hermann, 76131 Karlsruhe (DE); GUTHAUSEN, Gisela, 76131 Karlsruhe (DE); GROSS, Dieter, 75015 Bretten (DE); ZICK, Klaus, 75045 Walzbachtal (DE); PIETIG, Rainer, 76316 Malsch (DE); NIEMANN, Volker, 75228 Ispringen (DE)
(74) Representative: Kohler Schmid Möbus Patentanwälte

(56) References cited:
- WO-A1-2016/061875
- CN-B- 102 426 897
- US-A1- 2005 258 924
- US-A1- 2017 059 497
- FÖRSTER EVA ET AL: "NMR Diffusion and Relaxation for Monitoring of Degradation in Motor Oils", APPLIED MAGNETIC RESONANCE, SPRINGER VERLAG, VIENNA, AU, vol. 48, no. 1, 6 October 2016 (2016-10-06), pages 51-65, XP036130089, ISSN: 0937-9347, DOI: 10.1007/S00723-016-0842-0 [retrieved on 2016-10-06]

## Description

The invention relates to a Nuclear Magnetic Resonance (="NMR") fluid sensor arrangement with a magnet system comprising at least two permanent magnet elements and pole pieces attached to the magnet elements, whereby the magnet elements are disposed at an angle of 20° to 120° to each other, thus providing a V-shaped air gap between themselves, and whereby the magnet elements are attached to a generally V-shaped yoke support structure made of soft magnetic material and configured to resist attracting forces of the magnets and to provide a return path for the magnetic flux.

An NMR sensor arrangement of this kind is known from WO 2016/061875 A1 (= reference [0]).

### Background of the invention

In general, the present invention relates to the field of magnetic resonance (MR), in particular the provision of permanent magnet systems which are suitable for this purpose and which are intended to generate magnetic fields of various homogeneity for NMR measurements.

Nuclear magnetic resonance (NMR) is a commercially widespread method in MR for analyzing and characterizing the chemical composition of substances. In the area of NMR spectroscopy and in MR imaging, a very homogeneous and temporally constant magnetic field is required in a sample volume to be defined, said magnetic field being able to be generated with resistive or superconductive coils or with a suitable permanent magnet arrangement.

The use of permanent magnets is preferred if flux densities of currently well below 2T are sufficient and if a relatively compact structure is desired. The permanent magnets are typically held by a support structure, which can additionally perform the function of the magnetic return path. Traditional designs have a yoke in the form of a rectangular frame (window frame, H-yoke, C-yoke), with two central magnet assemblies arranged opposite each other, between which the sample volume is located. On account of their open structure, these yoke designs are also often affected by stray fields that extend far beyond the outer contours of the magnet arrangement.

Yoke-based magnets generally have a parallel pair of pole pieces made of a soft-magnetic material with suitably high saturation flux density. By suitable selection of the geometry of the pole pieces and special treatment of the surfaces, the field profile can be optimized in a comparatively simple and efficient way.

### Special prior art

US 10,345,251 B2 (= reference [2]) describes a portable NMR device to be used for determining an oil concentration in water. This portable NMR device comprises an unspecified magnetic field assembly and an analysis module which is configured to receive the NMR measurements data and to determine, based on the received NMR measurements the oil concentration that is present in the water. The document is silent about the kind of NMR measurement, the kind of magnet device and its homogeneity.

US 2007/0182413 A1 (= reference [3]) discloses a single-sided NMR sensor that are used to measure signal intensity, relaxation times and self-diffusion coefficients inside a sensitive volume generated in the sample by an open magnet. The device is conceived for scanning samples depth profiles. The magnet provides a strong magnetic field gradient but not a homogenous magnetic field.

WO 2019/072567 A1 (= reference [4]) describes a sensor for a nuclear magnetic resonance device for determining at least one material property of a material sample arranged in a useful volume. The NMR device comprises: a magnetic field generation apparatus comprising a planar magnet arrangement for generating a static magnetic field in the useful volume, the planar magnet arrangement having a plurality of magnetic poles on a front side facing the useful volume, which magnetic poles are arranged adjacent to each other along a first extension direction X of the planar magnet arrangement with alternating orientation, and a measuring apparatus for measuring a signal based on nuclear magnetic resonance of the material sample arranged in the useful volume. The NMR sensor according to reference [4] provides the possibility of NMR measurements in different magnetic environments. It does, however, not anticipate the idea of a magnet arrangement having *both* a homogenous magnetic field *and* a field gradient.

Förster et al. (= reference [5]) describe the method for data acquisition and processing using NMR methods such as spectroscopy, diffusometry and relaxometry. In this paper is shown that the use of a gamma distribution model for diffusion and also for T1 and T2 relaxation data numerically describes the data with high accuracy. Consequently, it is proposed to use said data processing to interpret the quality of used engine or gear oils. Given that this method is in public domain, a method covering the applied method by using the Gamma function algorithm is not novel and thus not patentable. However, most measurements were performed in a conventional NMR-instrument providing a clear separation between relaxation and diffusion. Additionally, single-sided NMR was used which is different from the dedicated sensor in this application by - selection of the sensitive volume - magnetic field distribution. The data acquisition and data processing schemes will be explored for the new situation of magnetic fields - regarding B0 and B1.

US 2017/0059497 A1 (= reference [1]) discloses a nuclear magnetic resonance sensor comprising two or more permanent magnets disposed proximate to each other ("single sided"). The magnets are configured to create a magnetic field, possibly with a gradient. The NMR sensor is used for measuring oil samples by determining properties comprises porosity, T1 or T2 relaxation times, a diffusion coefficient, permeability, or combinations thereof.

### Object of the invention

An object of the present invention is to provide a dedicated NMR-based sensor arrangement in accordance with claim 1 and of the type defined in the introduction above, especially for the characterization of liquids like oils in a quality control environment. The sensor should be suitable for characterization of complex mixtures including oils using a special low field NMR-magnet with regions of homogeneous magnetic field and with regions with strong static magnetic field gradients, where relaxation and/or diffusion can be measured, preferably but not exclusively by 1H-NMR.

Either the physically relevant quantities and their distributions can be extracted, or weighted measures can be extracted which is often the procedure in dedicated quality control applications of low field NMR. The sensor should be designed such that complex mixtures in standard tubes fit into the instrument. Moreover, there is the possibility to perform in-line measurements in various applications (engines, bearings, gears, etc., also in the food and diverse other industries). The materials should be measured straightforward without additional sample preparation. The NMR sensor arrangement should sport a compact construction.

### Brief description of the invention

This object is achieved by the present invention, in a surprisingly simple and effective way, in that the magnet system is constructed for generating a homogeneous magnetic B0 field in the direction of a z axis between a north magnetic pole and a south magnetic pole, allowing spectroscopic NMR measurements in a first volume and at least one gradient magnetic field in a second volume at a distance from the first volume with the homogeneous magnetic B0 field, both volumes being located inside the V-shaped air gap between the magnet elements, and that the magnet system is configured to create a homogenous magnetic field B0 within the air gap by means of the pole pieces being arranged with a chamfered part at the inner end of the V-shaped air gap. The Z axis is perpendicular to the central symmetry axis of the V-shaped magnet system.

In the frame of the present invention a homogenous magnetic field is defined as a magnetic field having of low or zero gradient and a minimum homogeneity thus allowing spectroscopic NMR measurements in a volume of interest.

The NMR sensor arrangement according to the invention is especially adapted for the characterization of liquids like oils in a quality control environment. In particular but not restricted to, the fluid to be measured can be an engine or a gear oil. With the NMR sensor the oil's quality and actual degree of ageing can be determined by means of diffusion and/or relaxation measurements in the time domain.

As an example of a complex liquid, we refer to oil, which, however, is not excluding other materials. Oil analytics currently is done by a number of analytical tools, including viscosity, acid number, infrared spectroscopy and others. The results of several analytical methods are needed to obtain a comprehensive view on the oils and to prove the functionality. As the market and the amount of oils are rather large, ecological and economical arguments make a reliable, easily performable and robust analytics mandatory.

Apart from well-known investigations of oil in NMR spectroscopy -most often performed in superconducting magnets with excellent magnetic field homogeneity and sensitivity due to large magnetic fields, low field NMR exhibits characteristics, which are highly appreciated in quality control in an industrial environment - including commercially active analytic laboratories.

For these purposes, the NMR sensor according to the present invention exhibits an open magnet design in order to perform direct measurements also with samples of greater outer diameter without the need of complicated rearrangements. Therefore, the invention proposes the V-shape of the magnet system so that the sensor can be easily held or clamped to the outer surface of e.g. an oil pipeline or the like for conveniently measuring the actual properties of the oil flowing through. The magnet elements of the magnet system preferably have planar surfaces. The pole pieces are attached to the (planar) surfaces of said magnet elements and have also essentially planar surfaces.

For a better adjustment of the magnetic field between the magnetic poles and for compensating manufacturing tolerances, the pole pieces can be provided with mechanical adjustment structures, such that the pole pieces can be displaced on the magnet surface and positioned to provide the desired special distribution of the magnetic field. These mechanical adjustment structures of the pole pieces, such as e.g. adjustment screws or jacking screws, are preferred for making large corrections of the magnetic field.

In a preferred embodiment, the magnet system can be equipped with a shimming system disposed at the surface of the magnet elements or the pole pieces for spatially correcting in particular the homogenous magnetic field B0. Passive shims or shim wires can be used. Passive shimming is achieved either through the placement of small pieces of magnetizable materials, which are known in the art, or by incorporating the shim structures directly into the pole pieces, e.g. by engraving. The advantage of passive shims is that they only require little space and are relatively easy to manufacture.

It is also possible to use active shims which utilize wires that carry electrical current for creating magnetic fields in the region of space around the wires, that can be used to correct the magnetic field. Active shims are more elaborate as they require more space and a separate power supply system.

Another important aspect of the invention is the availability of an area with a homogeneous magnetic B0 field for performing NMR spectroscopic measurements in a first volume in the direct proximity of another area with a gradient magnetic field in a second volume.

The arrangement according to the invention typically comprises a low field NMR-system
- with a permanent magnet-based dedicated magnet system with a large aperture angle providing a region of relatively strong and relatively homogeneous magnetic field and regions with strong static magnetic field gradients; and optionally,
- with radio frequency (=RF) coils with different geometries (including saddle coils, solenoids, surface coils) for handling different sample sizes at different positions in the magnet including the possibility to measure inline in a process stream;
- combined with data processing methods used for the characterization and differentiation of the fluids by means of diffusion and relaxation properties included in the measured magnetization signal; and
- dedicated data analysis tools depending on the NMR pulse sequence and the position in the magnet and the optional connection to a database for the classification and evaluation of the measurement results.

Further to the pole pieces, the permanent magnet elements also comprise yoke elements made of soft magnetic material.

To be more flexible, the RF coils can be exchanged allowing for different sample sizes and positions in the magnet, which also introduces a different weighting of the NMR properties named above.

As the measurements are robust against small temperature drifts, thermal insulation and temperature regulation is not necessary in many applications. However, thermal insulation and temperature regulation might be added, when widening the application field of the sensor. Adaptation for inline applications are considered too.

In contrast, high-field NMR spectroscopy, spectrally resolved diffusion and relaxation, relaxation and diffusion measurements based on existing low field NMR devices, having a limited field of view: No inline-capable solutions are available, the devices are too complex and costly to invest and maintain, the sample size is usually restricted, i.e. special sample preparation is necessary. Alternative techniques are IR spectroscopy, mass spectrometry etc. Further, conventional NMR spectroscopy or infrared spectroscopy result in a different information content.

### Preferred embodiments and developments of the invention

An embodiment of the sensor arrangement according to the invention is particularly preferred, in which a sample holder is mechanically coupled to the magnet system for holding a sample within a measuring volume of the sensor arrangement.

In an advantageous further development of said embodiment, the sample holder is arranged in a holding device forming a module being adapted to be attached to the V-shaped magnet system.

The sample holder can be formed as a tube for performing in-line NMR-measurements.

A further beneficial embodiment is characterized in that the magnet system is a low field NMR magnet system generating a maximum magnetic field strength between 0,1T and 1,9T, in particular 0,5T to 1T.

A class of embodiments of the NMR sensor arrangement according to the invention is particularly preferred in which a probe comprising at least one RF circuit with an RF-coil configured for exciting and detecting an NMR signal is placed in the V-shaped air gap between the magnet elements.

Particularly preferred developments in the aforementioned class of embodiments are distinguished by virtue of the probe comprising an RF-circuit with a first RF-coil in the area of the first volume with a homogeneous magnetic B0 field and a second RF-circuit with a second RF-coil in the area of the second volume with a static gradient magnetic field.

Preferably, the RF-coils are designed such that they can be exchanged with other RF-coils having different geometries.

Further preferred developments of this sensor arrangement are characterized in that the RF-coils comprise solenoid coils for static NMR measurements.

Alternatively, the NMR sensor arrangement can be characterized in that the second RF-coil in the area of a second volume has an open geometry, in particular being a saddle coil, a solenoid or a surface coil, thereby allowing for handling of samples at different positions within the magnet system and the adaptation to a pipe in which the liquid to be characterized flows. For this embodiment, the sample holder is preferably structured to fit with the pipe, e.g. the sample holder forms a half pipe which the user can attach or press against the pipe containing the sample to be measured.

Both arrangements are suitable for inline measurements but only the latter arrangement is suitable for a handheld measurement, for which the device can be held with the V-opening to an object to be measured, e.g. a pipeline.

In another favourable development in the aforementioned class of embodiments, the RF-circuits comprise a Q-switch to maintain short T2 and/or fast diffusion measurements.

Yet another favourable development is characterized in that the sensor arrangement comprises a central processing unit coupled to the probe and configured to process acquired time domain data from the NMR sensor arrangement, whereby the acquired time domain data are preferably T2 relaxation data and/or diffusion data or both simultaneously.

The present invention preferably uses a method for operating the above NMR sensor arrangement, characterized in that data processing methods are used for the characterization and differentiation of fluids by means of diffusion and relaxation properties included in the measured magnetization signal in the second volume and for spectroscopic NMR measurements in the first volume.

An advantageous variant of this method is characterized in that dedicated data analysis tools are employed depending on the NMR pulse sequence and the position in the magnet system as well as an optional connection to a database for the classification and evaluation of the measurement results.

A further method variant is also preferred in which the data acquisition of T2 relaxation is based on signals received from the RF-coil in the static magnetic gradient area of the sensor arrangement with a gradient strength between 2T/m and 10T/m.

Further advantages of the invention will become clear from the description and from the drawing. Similarly, according to the invention, the features mentioned above and the features that are set out further below can be used singly or in any desired combinations. The embodiments that are shown and described should not be understood as an exhaustive list, but rather as examples used to explain the invention.

### Detailed description of the invention and drawing

The invention is shown in the drawing and is explained in more detail on the basis of illustrative embodiments.

In the drawing:
- Fig. 1: shows a schematic cross-sectional view through an embodiment of the NMR sensor according to the invention in a direction perpendicular to a z-axis of the magnetic field generated by the magnet system;
- Fig. 2: shows a cross section in a direction perpendicular to a z-axis through an embodiment similar to Fig.1, however with RF-coils schematically indicated around an NMR sample in the volume of homogenous magnetic field and a schematic tuning box for the RF system;
- Fig. 3: shows a cross section through the embodiment of Fig. 2 along the z-axis;
- Fig. 4: shows a cross section in a direction perpendicular to a z-axis through an embodiment similar to Fig.1, however bisected along the symmetry axis and with an additional shim element;
- Fig. 5: shows the magnetic field along the symmetry axis from the closed end of the V-shaped magnet arrangement according to the invention towards the opening;
- Fig. 6: shows a plan view of an embodiment of the NMR sensor according to the invention;
- Fig. 7: shows the device of Fig. 6 with the holding device comprising the cover plate being omitted; and
- Fig. 8: shows the device of Fig. 7 with a second open coil arranged in the second volume with gradient magnetic field and the holding device being omitted.

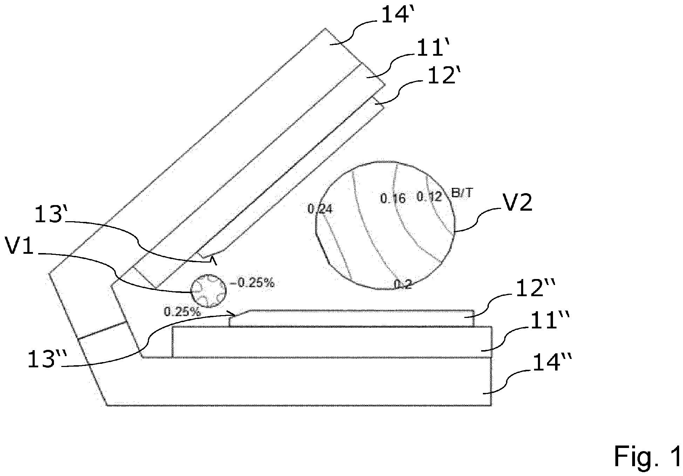

The Nuclear Magnetic Resonance (="NMR") fluid **sensor arrangement 1** according to the invention, as shown schematically in the cross-sectional views of Figures 1 through 4 comprise a magnet system with at least two permanent **magnet elements 11'; 11"** and **pole pieces 12'; 12"** attached to the magnet elements 11'; 11". The arrangement 1 further comprises **yoke elements 14'; 14"** made of magnetic material.

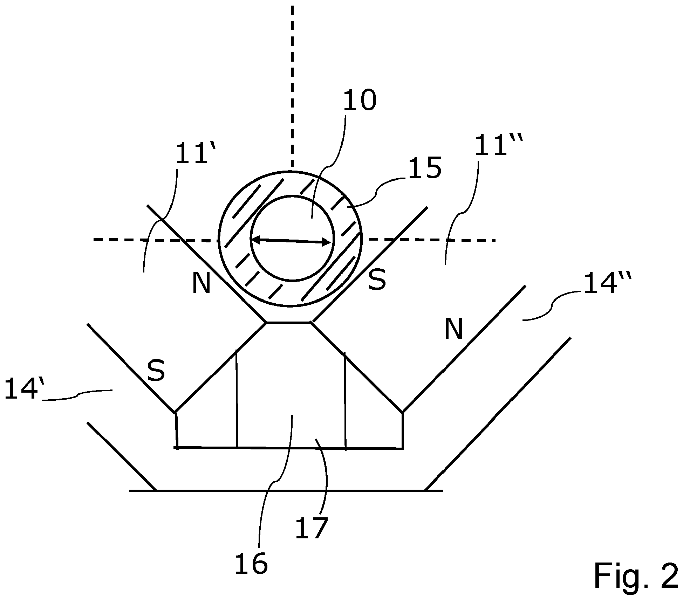

As can be taken from Figures 1 and 2, the magnet elements 11'; 11"
- are disposed at an angle of 20° to 120° to each other, thus providing a V-shaped air gap between themselves, and have generally flat surfaces;
- are attached to a generally V-shaped yoke support structure made of soft magnetic material and configured to resist attracting forces of the magnets, to shield the B0 field to the outside and to provide a return path for the magnetic flux.

The pole pieces 12'; 12" have also generally flat surfaces, which are attached to the flat surfaces of the magnet elements 11'; 11"

The magnet system is constructed for generating a homogeneous magnetic B0 field in the direction of a z-axis in a **first volume V1** and at least one gradient magnetic field in a **second volume V2** located at a distance from the first volume V1 with the homogeneous magnetic B0 field, both volumes V1, V2 being located inside the V-shaped air gap between the magnet elements 11'; 11".

Fig. 1 depicts an embodiment of the invention, in which, in accordance with the invention, the magnet system is configured to create a homogenous magnetic field B0 within the air gap by means of the pole pieces 12'; 12" being arranged with a **chamfered part 13'; 13"** at the inner end of the V-shaped air gap. The same chamfered geometry is also realized in other embodiments of the invention.

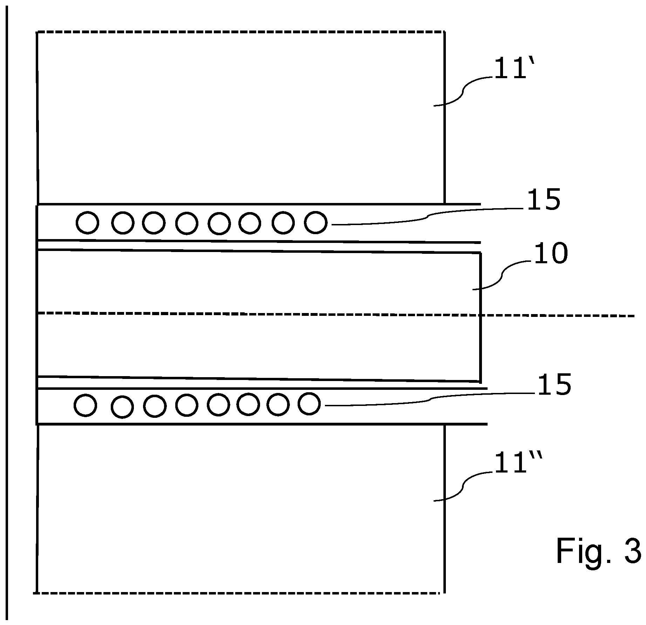

In Figures 2 and 3 some further elements of the NMR fluid sensor arrangement 1 according to the invention are schematically indicated:
An **NMR measuring sample 10** is surrounded by **RF-coils 15** and arranged in the volume V1 of homogeneous magnetic field shown in Fig. 1. The RF system is electronically controlled by a **tuning box 16** from which an **RF control and feeding plug 17** is running away from the sensor arrangement 1.

The NMR sensor according to the invention is equipped with a V-shaped permanent magnet system which is designed to provide a homogeneous region and regions with at least one static field gradient. This magnet system offers the possibility of having at least two positions in a single magnet which allow different NMR measurements: In the area with a homogeneous magnetic field the T2 relaxation can be observed. The area with constant magnetic field gradients (in the order of 2-10 T/m) allows the observation of T2 relaxation with simultaneous diffusion attenuation of the NMR signal. Hence this system allows an extended specification of the substances to be investigated. Additionally, the modular design allows correlative measurements without additional sample preparation, but direct comparability and comprehensiveness of analytics.

This NMR sensor is designed to evaluate the quality of liquids, but it is not limited to these applications.

The magnet is designed with a V-shape having an opening angle of 20° to 120°. In the present embodiment, the opening angle is 44°. The V-shaped support structure is preferably made of a soft magnetic material to form a yoke. The magnets are attached on either side of the yoke for producing a magnetic field in an area inside the V. The function of the yoke is twofold: it provides the magnetic flux and it ensures sufficient stability with respect to the magnetic force. The maximum field strength is from 0,1T to 1,9T, in a preferred embodiment 0,5T to 1T depending on the magnetic material used and its mass, thus corresponding to a 1H Larmor frequency from about 4 MHz to 80 MHz.

The temperature dependency of the NMR sensor and the measurement is usually negligible as the measurements are short, the Larmor frequency therefore within the band width of the strong and therefore short B1 pulses and the magnetic field gradient has a negligible temperature dependency. So, the device can be used as a versatile portable sensor for applications in a large temperature scale.

The magnets are attached on either leg of the iron yoke. In this embodiment an NdFeB material is used to provide a relatively homogenous magnetic field of 0,5 T in the centre of the magnet which is at the closed end of the V- shaped yoke. A static magnetic field gradient of about 4 T/m is achieved at the open end of the V-shaped magnet. For diffusion measurements on typical oils the gradient should be at least 2 T/m. The field variation along the symmetry axis is shown as half circles.

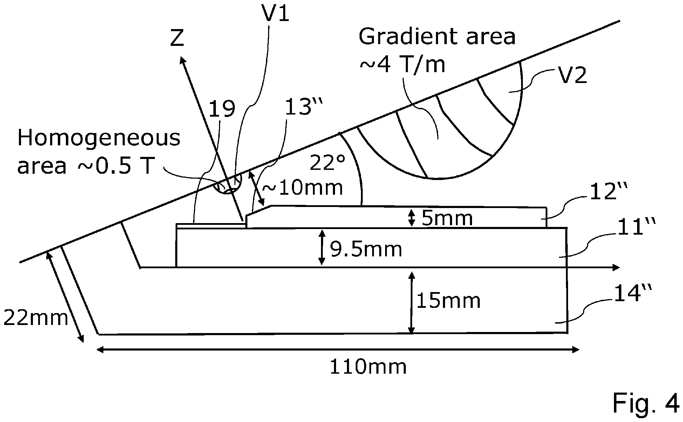

Fig. 4 shows in principle the same cross section as Fig. 1, which is, however, bisected along a symmetry axis. A pole piece 12" is attached to the magnetic material of magnet element 11" for providing uniform field lines. Again, the inner end the surface of the pole piece 12" has a chamfered surface 13" for parallelizing the field lines in the centre of the magnet arrangement which leads to a broadening of the homogenous area to a maximum of about 10 mm which is shown as bisected volume V1. It is well-known to a skilled person that for smaller sample volumes it is easier to obtain the necessary magnetic field homogeneity which allows spectroscopic NMR measurements. It is thus preferred to use smaller sample tubes of a diameter less than 2 mm. The larger gradient region V2 is presented as a half circle. In addition to the embodiment of Fig. 1, an extra **shim element 19** is provided for improving the homogeneity in the volume V1.

Further, in Fig. 4 preferred dimensions of the embodiment are indicated. The NMR sensor is relatively compact, and it allows diffusion measurements in the strong gradient region as well as dominantly T2 measurements in a relatively homogenous region without significant diffusion weighting.

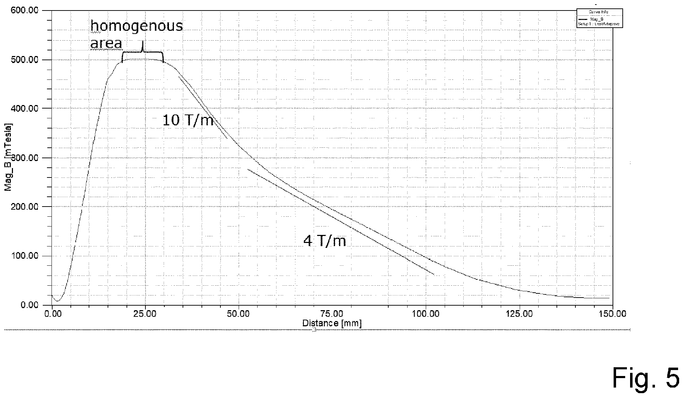

Fig. 5 shows the magnetic field along the symmetry axis from the closed end of the V-shaped magnet arrangement towards the opening. The V-shaped magnet design provides a relatively homogenous central region between 20-30 mm along the central symmetry axis from the closed end, provided by the chamfered pole piece design.

Moreover, in the plot of Fig. 5 two regions of approximately constant magnetic field gradient along the center axis can be identified: 10 T/m between 33 and 45mm, 4 T/m between 60 and 100 mm. Especially the latter region allows the use of larger sample containers which are standardized for example in oil analysis. So, the size of the magnet opening and of the RF coil must match with the samples to be measured. The preferred maximum sample diameter in oil analysis is 42 mm, with a fill height up to 60 mm.

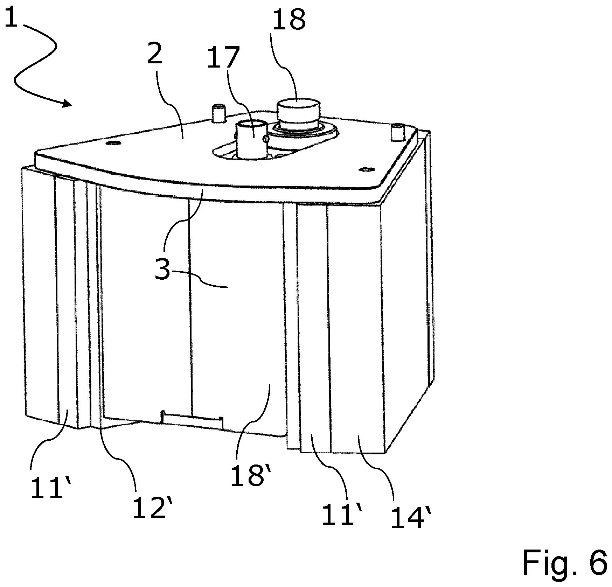

Fig. 6 shows a plan view of the NMR sensor in which a modular holding device is arranged between the V-shape magnets. In this design the probe head comprises only a single **sample holder 18** with an RF-coil arranged in the modular **holding device 18'.** The holding device 18' is simultaneously designed as an **RF shield 3,** comprising a **cover plate 2** and a housing part which shield the sample head against interfering RF radiation. The cover plate 2 is directly fixed to the yoke elements 14', 14". The holding device 18' could also be provided as a module comprising two or three sample holders. A connector for the RF coaxial feed line to the control unit is located on top of the device.

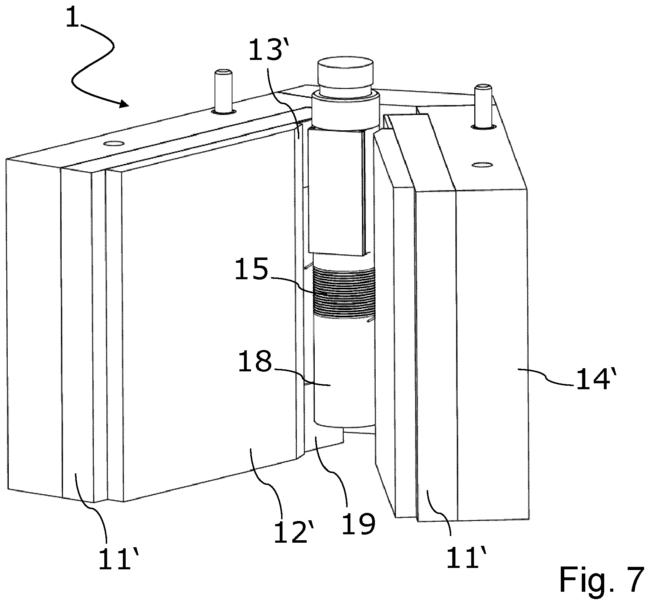

Fig. 7 shows the device of Fig. 6 whereas the holding device comprising the cover plate 2 is omitted such that the sample holder 18 with a solenoid RF-coil 15 can be recognized in the first volume with homogeneous magnetic field V1. It is understood that this embodiment with a solenoid coil allows essentially measurements with NMR tubes which are inserted into the sample holder 18 prior to the measurement.

It is also conceivable that a continuous line is positioned in the place of the sample holder 18 through which the sample (oil) is conducted for a continuous inline measurement. Such an inline control is useful for a continuous quality control of oily liquids. Examples are engine oils that are subject to ageing but also process oils in the (petro-) chemical industry.

Additional shim elements 19 are arranged on inner side of the magnet elements for further homogenizing the magnetic field especially in the first volume with homogeneous magnetic field V1.

The one-sided opening of the V-shaped sensor allows mobile on-site measurements, for which, the sensor is held on a hose or a tube with a liquid to be analysed. For these embodiments it is necessary to use an RF-antenna with an open or openable coil.

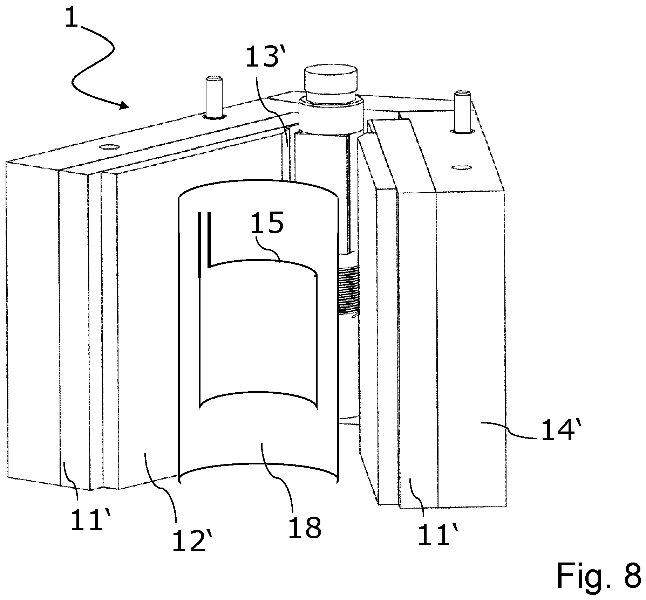

The embodiment of Fig. 8 shows the features of Fig. 7 with a second open coil 15 arranged in the second volume with gradient magnetic field. For a better view the holding device 18' is omitted in Fig. 8. The open coil 15 shown here is a saddle coil mounted on an open sample holder 18. Other open or openable coil geometries such as surface coils are also applicable. The open sample holder 18 has a semi-cylindrical half pipe shape, whereby the cylinder radius is ideally selected to correspond to the piping to be measured. In this design, the user can hold the NMR sensor 1 directly on the oil pipe to perform a measurement.

It is also possible to attach the sensor permanently to flow lines. In this case the geometry of the magnet and the RF coils 15 should be adapted accordingly.

The magnet has at least one region with a relatively homogenous magnetic field and at least one region with a strong static field gradient.

The sensor should still be light-weighted (4-10 kg) such that the instrument can be regarded as mobile or as a handheld device. The positioning of the magnet (including the RF unit) should be flexible such that samples can be measured horizontally or vertically, for example. For applications requiring smaller sample volumes, the NMR sensor 1 can easily be downscaled whilst maintaining the magnetic field strength and homogeneity.

The drift of the magnetic field is preferably less than 0,12 % of the main field per K, which corresponds to the specification of NdFeB magnet material. With the aim to produce a robust instrument, which is insensitive to environmental parameters like temperature, this point is substantial if not mandatory. Otherwise expensive techniques for temperature stabilisation and regulation would have to be realised, which are also in contradiction to the aim of a mobile operation of the sensor.

The design of the V-shaped magnet is robustly designed such that mechanical tolerances can be handled during the manufacture of this device. Special adjustment mimics or adjustment mechanisms are however useful to provide large corrections of the magnetic field.

The RF-coils can be among others solenoid coils with different diameters or surface coils. Surface coils allow for bigger samples, which do not fit into solenoid coils. Surface coils in this context can be shaped and need not necessarily to be flat. They are also well suited for selection of specific regions in a heterogeneous sample via the B1 field combined with the gradient of B0.

To allow investigation of materials with short transverse relaxation times the 90° RF-pulse must be sufficiently short.

### List of reference signs:

- 1: NMR sensor arrangement
- 2: cover plate
- 3: RF shield
- 10: NMR measuring sample
- 11'; 11": magnet elements
- 12'; 12": pole pieces
- 13'; 13": chamfered part at the inner end of the V-shaped air gap
- 14', 14": yoke elements
- 15: RF-coils
- 16: tuning box
- 17: RF control and feeding plug
- 18: sample holder
- 18': holding device
- 19: shim element
- V1: first volume with homogeneous magnetic field
- V2: second volume with gradient magnetic field

### Citations:

### Publications considered for assessing the patentability:

[0] WO 2016/061875 A1
[1] US 2017/0059497 A1
[2] US 10,345,251 B2
[3] US 2007/0182413 A1
[4] WO 2019/072567 A1
[5] E. Förster, H. Nirschl, G. Guthausen; "NMR Diffusion and Relaxation for Monitoring of Degradation in Motor Oils" Appl Magn Reson (2017) 48:51-65

## Claims

1. Nuclear Magnetic Resonance (="NMR") fluid sensor arrangement (1) with a magnet system comprising at least two permanent magnet elements (11'; 11") and pole pieces (12'; 12") attached to the magnet elements (11'; 11"),
whereby the magnet elements (11'; 11") are disposed symmetrically on both sides of a central symmetry axis at an angle of 20° to 120° to each other, thus providing a V-shaped air gap between themselves,
and whereby the magnet elements (11'; 11") are attached to a generally V-shaped yoke support structure made of soft magnetic material and configured to resist attracting forces of the magnets and to provide a return path for the magnetic flux,
**characterized in**
**that** the magnet system is constructed for generating a homogeneous magnetic B0 field in the direction of a z axis allowing spectroscopic NMR measurements in a first volume (V1) and at least one gradient magnetic field in a second volume (V2) located at a distance from the first volume (V1) with the homogeneous magnetic B0 field, both volumes (V1, V2) being located inside the V-shaped air gap between the magnet elements (11'; 11"), wherein the z axis is perpendicular to the central symmetry axis,
and **that** the magnet system is configured to create a homogenous magnetic field B0 within the air gap by means of the pole pieces (12'; 12") being arranged with a chamfered part (13'; 13") at the inner end of the V-shaped air gap.

2. NMR sensor arrangement (1) according to Claim 1, **characterized in that** the magnet system comprises a shimming system disposed at the surface of the magnet elements (11'; 11") or the pole pieces (12'; 12") for spatially correcting the homogenous magnetic field B0.

3. NMR sensor arrangement (1) according to any one of the preceding claims, **characterized in that** a sample holder (18) is mechanically coupled to the magnet system for holding a sample within a measuring volume of the sensor arrangement (1).

4. NMR sensor arrangement (1) according to claim 3, **characterized in that** the sample holder (18) is arranged in a holding device (18') forming a module being adapted to be attached to the V-shaped magnet system.

5. NMR sensor arrangement (1) according to any one of the preceding claims, **characterized in that** the magnet system is a low field NMR magnet system generating a maximum magnetic field strength between 0,1T and 1,9T, in particular 0,5T to 1T.

6. NMR sensor arrangement (1) according to any one of the preceding claims, **characterized in that** a probe comprising at least one RF circuit with an RF-coil configured for exciting and detecting an NMR signal is placed in the V-shaped air gap between the magnet elements (11'; 11").

7. NMR sensor arrangement (1) according to claim 6, **characterized in that** the probe comprises an RF-circuit with a first RF coil in the area of the first volume (V1) with a homogeneous magnetic B0 field and a second RF-circuit with a second RF coil in the area of the second volume (V2) with a static gradient magnetic field.

8. NMR sensor arrangement (1) according to any one of claims 6 or 7, **characterized in that** the RF-coils comprise solenoid coils for static NMR-measurements.

9. NMR sensor arrangement (1) according to any one of claims 6 or 7, **characterized in that** the second RF-coil in the area of the second volume (V2) has an open geometry, in particular being a saddle coil, a solenoid or a surface coil, thereby allowing for handling of samples at different positions within the magnet system.

10. NMR sensor arrangement (1) according to one or more of claims 6 to 9, **characterized in that** the RF-circuits comprise a Q-switch to maintain short T2 and/or fast diffusion measurements.

11. NMR sensor arrangement (1) according to one or more of claims 6 to 10, **characterized in that** the arrangement (1) comprises a central processing unit coupled to the probe and configured to process acquired time domain data from the NMR sensor arrangement (1), whereby the acquired time domain data are preferably T2 relaxation data and/or diffusion data or both simultaneously.

## Patentansprüche

1. Kernspinresonanz(="NMR") Fluidsensoranordnung (1) mit einem Magnetsystem, umfassend mindestens zwei Permanentmagnetelemente (11'; 11") und an den Magnetelementen (11'; 11") befestigte Polstücke (12'; 12"),
wobei die Magnetelemente (11'; 11") symmetrisch auf beiden Seiten einer zentralen Symmetrieachse in einem Winkel von 20° bis 120° zueinander eingerichtet sind und so einen V-förmigen Luftspalt zwischen sich bereitstellen,
und wobei die Magnetelemente (11'; 11") an einer im Allgemeinen V-förmigen Jochträgerstruktur befestigt sind, die aus weichmagnetischem Material besteht und so ausgelegt ist, dass sie Anziehungskräften der Magnete widersteht und einen Rückflusspfad für den magnetischen Fluss bereitstellt,
**dadurch gekennzeichnet,**
**dass** das Magnetsystem zum Erzeugen eines homogenen magnetischen Feldes B0 in Richtung einer z-Achse, das spektroskopische NMR-Messungen in einem ersten Volumen (V1) ermöglicht, und mindestens eines Gradientenmagnetfeldes in einem zweiten Volumen (V2), das sich in einem Abstand vom ersten Volumen (V1) zu dem homogenen magnetischen Feld B0 befindet, aufgebaut ist, wobei sich beide Volumina (V1, V2) innerhalb des V-förmigen Luftspaltes zwischen den Magnetelementen (11'; 11") befinden, und wobei die z-Achse senkrecht zur zentralen Symmetrieachse ist,
und **dass** das Magnetsystem so ausgelegt ist, dass es ein homogenes Magnetfeld B0 innerhalb des Luftspaltes erzeugt, indem die Polstücke (12'; 12") mit einem abgeschrägten Teil (13'; 13") am inneren Ende des V-förmigen Luftspaltes angeordnet sind.

2. NMR-Sensoranordnung (1) nach Anspruch 1, **dadurch gekennzeichnet, dass**
das Magnetsystem ein an der Oberfläche der Magnetelemente (11'; 11") oder der Polstücke (12'; 12") eingerichtetes Shim-System zur räumlichen Korrektur des homogenen Magnetfeldes B0 umfasst.

3. NMR-Sensoranordnung (1) nach einem der vorhergehenden Ansprüche, **dadurch gekennzeichnet, dass** ein Probenhalter (18) mit dem Magnetsystem zum Halten einer Probe in einem Messvolumen der Sensoranordnung (1) mechanisch gekoppelt ist.

4. NMR-Sensoranordnung (1) nach Anspruch 3, **dadurch gekennzeichnet, dass** der Probenhalter (18) in einer Haltevorrichtung (18') angeordnet ist, die ein Modul bildet, das dazu eingerichtet ist, am V-förmigen Magnetsystem befestigt zu werden.

5. NMR-Sensoranordnung (1) nach einem der vorhergehenden Ansprüche, **dadurch gekennzeichnet, dass** das Magnetsystem ein Niederfeld-NMR-Magnetsystem ist, das eine maximale magnetische Feldstärke zwischen 0,1 T und 1,9 T, insbesondere 0,5 T bis 1 T erzeugt.

6. NMR-Sensoranordnung (1) nach einem der vorhergehenden Ansprüche, **dadurch gekennzeichnet, dass** im V-förmigen Luftspalt zwischen den Magnetelementen (11'; 11'') eine Sonde angeordnet ist, die mindestens einen HF-Schaltkreis mit einer zur Anregung und Detektion eines NMR-Signals ausgelegten HF-Spule umfasst.

7. NMR-Sensoranordnung (1) nach Anspruch 6, **dadurch gekennzeichnet, dass** die Sonde einen HF-Schaltkreis mit einer ersten HF-Spule im Bereich des ersten Volumens (V1) mit einem homogenen Magnetfeld B0 und einen zweiten HF-Schaltkreis mit einer zweiten HF-Spule im Bereich des zweiten Volumens (V2) mit einem statischen Gradientenmagnetfeld umfasst.

8. NMR-Sensoranordnung (1) nach einem der Ansprüche 6 oder 7, **dadurch gekennzeichnet, dass** die HF-Spulen Magnetspulen für statische NMR-Messungen umfassen.

9. NMR-Sensoranordnung (1) nach einem der Ansprüche 6 oder 7, **dadurch gekennzeichnet, dass** die zweite HF-Spule im Bereich des zweiten Volumens (V2) eine offene Geometrie aufweist, insbesondere eine Sattelspule, eine Magnetspule oder eine Oberflächenspule ist, wodurch die Handhabung von Proben an unterschiedlichen Positionen innerhalb des Magnetsystems ermöglicht wird.

10. NMR-Sensoranordnung (1) nach einem oder mehreren der Ansprüche 6 bis 9, **dadurch gekennzeichnet, dass** die HF-Schaltkreise einen Q-Schalter zur Aufrechterhaltung von Messungen mit kurzem T2 und/oder schneller Diffusion umfassen.

11. NMR-Sensoranordnung (1) nach einem oder mehreren der Ansprüche 6 bis 10, **dadurch gekennzeichnet, dass** die Anordnung (1) eine zentrale Verarbeitungseinheit umfasst, die mit der Sonde gekoppelt und so ausgelegt ist, dass sie von der NMR-Sensoranordnung (1) erfasste Zeitdomänendaten verarbeitet, wobei die erfassten Zeitdomänendaten vorzugsweise T2-Relaxationsdaten und/oder Diffusionsdaten oder beides gleichzeitig sind.

## Revendications

1. Agencement de capteur(s) de fluide à résonance magnétique nucléaire (= "RMN") (1) muni d'un système d'aimants qui comprend au moins deux éléments d'aimant permanent (11'; 11") et au moins deux pièces polaires (12'; 12") qui sont liées aux éléments d'aimant permanent (11'; 11"),
d'où il résulte que les éléments d'aimant permanent (11'; 11") sont disposés de façon symétrique sur les deux côtés d'un axe de symétrie central selon un angle de 20° à 120° l'un par rapport à l'autre ou les uns par rapport aux autres, d'où ainsi la constitution d'un espace d'air ou entrefer en forme de V entre eux ; et
d'où il résulte que les éléments d'aimant permanent (11'; 11") sont liés à une structure de support de culasse présentant la forme générale d'un V qui est réalisée en un matériau magnétique doux et qui est configurée pour résister à des forces d'attraction des aimants et pour constituer une voie de retour pour le flux magnétique ;
**caractérisé en ce que** :
le système d'aimants est construit pour générer un champ magnétique homogène B0 dans la direction d'un axe z, ce qui permet des mesures RMN spectroscopiques dans un premier volume (V1), et pour générer au moins un champ magnétique à gradient dans un second volume (V2) qui est localisé à une distance du premier volume (V1) qui présente le champ magnétique homogène B0, les deux volumes (V1, V2) étant localisés à l'intérieur de l'espace d'air ou entrefer en forme de V entre les éléments d'aimant permanent (11'; 11"), dans lequel l'axe z est perpendiculaire à l'axe de symétrie central ; et **en ce que** :
le système d'aimants est configuré pour créer un champ magnétique homogène B0 à l'intérieur de l'espace d'air ou entrefer au moyen des pièces polaires (12'; 12") qui sont agencées de manière à présenter une partie chanfreinée (13'; 13") au niveau de l'extrémité interne de l'espace d'air ou entrefer en forme de V.

2. Agencement de capteur(s) RMN (1) selon la revendication 1, **caractérisé en ce que** le système d'aimants comprend un système de compensation qui est disposé au niveau de la surface des éléments d'aimant permanent (11'; 11") ou des pièces polaires (12'; 12") pour corriger spatialement le champ magnétique homogène Ba.

3. Agencement de capteur(s) RMN (1) selon l'une quelconque des revendications précédentes, **caractérisé en ce qu'**un support d'échantillon(s) (18) est couplé mécaniquement au système d'aimants pour supporter ou contenir un échantillon à l'intérieur d'un volume de mesure de l'agencement de capteur(s) RMN (1).

4. Agencement de capteur(s) RMN (1) selon la revendication 3, **caractérisé en ce que** le support d'échantillon(s) (18) est agencé à l'intérieur d'un dispositif de support ou de contenance (18') qui forme un module qui est adapté pour être lié au système d'aimants en forme de V.

5. Agencement de capteur(s) RMN (1) selon l'une quelconque des revendications précédentes, **caractérisé en ce que** le système d'aimants est un système d'aimants RMN à champ faible qui génère une intensité de champ magnétique maximum entre 0,1 T et 1,9 T, en particulier entre 0,5 T et 1 T.

6. Agencement de capteur(s) RMN (1) selon l'une quelconque des revendications précédentes, **caractérisé en ce qu'**une sonde qui comprend au moins un circuit radiofréquence/RF muni d'une bobine RF qui est configurée pour exciter et détecter un signal RMN est placée à l'intérieur de l'espace d'air ou entrefer en forme de V entre les éléments d'aimant permanent (11'; 11").

7. Agencement de capteur(s) RMN (1) selon la revendication 6, **caractérisé en ce que** la sonde comprend un circuit RF muni d'une première bobine RF dans la zone du premier volume (V1) présentant un champ magnétique homogène B0 et un second circuit RF muni d'une seconde bobine RF dans la zone du second volume (V2) présentant un champ magnétique à gradient statique.

8. Agencement de capteur(s) RMN (1) selon l'une quelconque des revendications 6 ou 7, **caractérisé en ce que** les bobines RF comprennent des bobines de solénoïde pour des mesures RMN statiques.

9. Agencement de capteur(s) RMN (1) selon l'une quelconque des revendications 6 ou 7, **caractérisé en ce que** la seconde bobine RF dans la zone du second volume (V2) présente une géométrie ouverte, en particulier, il s'agit d'une bobine en sellette, d'un solénoïde ou d'une bobine de surface, ce qui permet par voie de conséquence de gérer des échantillons au niveau de positions différentes à l'intérieur du système d'aimants.

10. Agencement de capteur(s) RMN (1) selon une ou plusieurs des revendications 6 à 9, **caractérisé en ce que** les circuits RF comprennent un commutateur déclencheur Q pour maintenir des mesures de relaxation T2 courte/ou de diffusion rapide.

11. Agencement de capteur(s) RMN (1) selon une ou plusieurs des revendications 6 à 10, **caractérisé en ce que** l'agencement de capteur(s) (1) comprend une unité centrale de traitement qui est couplée à la sonde et qui est configurée pour traiter les données acquises du domaine temporel en provenance de l'agencement de capteur(s) RMN (1), d'où il résulte que les données acquises du domaine temporel sont de préférence des données de relaxation T2 et/ou des données de diffusion ou les deux simultanément.
